# EUROPEAN PATENT SPECIFICATION

(11) **EP 3 405 011 B1**
(45) Date of publication and mention of the grant of the patent: **10.09.2025**
(21) Application number: 17305560.9
(22) Date of filing: 16.05.2017
(51) Int. Cl.: H05K 1/03, H05K 3/28, B32B 29/00

(54) **PAPER-IN-RESIN ELECTRONICS - PROCESS FOR PRODUCING IT**
PAPER-IN-HARZ-ELEKTRONIK - VERFAHREN ZUR HERSTELLUNG DAVON
ÉLECTRONIQUE DE PAPIER EN RÉSINE, SON PROCÉDÉ DE FABRICATION

(43) Date of publication of application: 21.11.2018
(73) Proprietor: FEDRIGONI S.P.A., 37135 Verona (IT)
(72) Inventor: DEPRES, Gaël, 38850 Chirens (FR); VAU, Jean-Marie, 75012 Paris (FR)
(74) Representative: Modiano, Micaela Nadia

(56) References cited:
- WO-A1-2016/128953
- US-A1- 2011 135 849
- US-A1- 2011 293 851
- US-A1- 2014 322 500
- US-A1- 2015 296 612
- US-A1- 2016 251 805
- LUCIA LEONAT ET AL: "4% Efficient Polymer Solar Cells on Paper Substrates", JOURNAL OF PHYSICAL CHEMISTRY C, vol. 118, no. 30, 31 July 2014 (2014-07-31), US, pages 16813 - 16817, XP055443622, ISSN: 1932-7447, DOI: 10.1021/jp5020912

## Description

### Background of the invention

The invention relates to "Paper in Resin electronics" and accordingly provides a paper-based printed electronic device impregnated and encapsulated with a resin, which is in a form of a monolithic structure, in particular a flat or curved monolithic structure. The (in particular flat or curved) monolithic structure may in particular be obtained by carrying out a lamination process. As such, the paper-based printed electronic device (hereafter the electronic device for convenience) may then be integrated or embedded into a product or an object including by performing a lamination process while providing at the same time the monolithic structure. Accordingly the invention relates to the preparation of electronic devices that may be involved in Internet-of-Things wherein the electronic device would be embedded in different materials (paper, wood, glass, plastics...).

Printed electronics enables electrically functional inks to be printed on a range of flexible substrates to form circuitries that can fulfill many different functions in applications such as smart objects, displays, communication devices, RFID tags, sensors, energy harvesting devices, to name a few.

Among various flexible substrates, paper serves an attractive alternative to plastic film due to its thermal stability and recyclability. Patent applications WO 2013/104520 and WO2015/059157 disclose paper substrates suitable for printing functional inks for printed electronics, which exhibit suitable smoothness, high thermal stability, and ink absorption characteristics that allow less quantity of inks to be applied on said paper substrates to achieve desired electrical properties, such as electrical conductivity.

US2011135849 A1 relates to multilayered articles for building interiors and in automobiles. WO2016/128953 A1 relates to wood derived multilayer products, profiles, framed, laminate or compact products, among others, with integrated electric circuits, for example capacitive sensors, and the fabrication process thereof.

Nevertheless, paper substrates are prone to tearing and hygroscopic in nature (i.e. cellulose fibers absorb moisture from the surrounding environment), which limit their use in wider applications. In fact, most electronic devices require an excellent barrier against environmental factors such as moisture, oxygen, and physical damages which are contributors to degradation, reduced lifetime, or failure. Especially, paper-based electronics in the applications of ultra-high frequency (UHF), Wi-Fi, Bluetooth Low Energy (BLE) or even higher frequency antenna confront difficulties due to considerable dielectric losses at high frequency (above 1 GHz). Thus, there exists a need for an effective protection of paper based electronics against moisture, oxygen, and physical damages.

Encapsulation of electronic devices by lamination with plastic films is known. Similarly, electronic devices can be embedded in injection-moulded plastics. It has been also shown that electronic devices are first laminated with plastic films and then incorporated in an In-Mould Process. However, the use of plastic films to encapsulate electronic devices and/or embedding electronic devices in injection-moulded plastics have several important drawbacks that selected papers do not exhibit.
- In high temperature sintering, plastic films show noticeable drop in their physical characteristics. A temperature range of 120 °C to 140 °C is the maximum processing temperature range for polyethylene terephthalate (PET) and polyethylene naphthalate (PEN), whereas paper can withstand temperatures up to 200 °C to 220 °C without significant decrease in mechanical properties. Sintering is usually required for obtaining functional electronic circuits from substrates printed with electronic ink, in particular with inks comprising metallic particles. Lower temperature sintering, due to temperature constraints of the substrate, induces the need for higher amount of expensive electronic inks, in order to reach the desired electronic properties.
- Due to their higher temperature sensitivity compared to paper, plastic films show a poor thermal dimensional stability. This drawback causes registration issues during the printing steps.
- Plastic films are more difficult to print by basic techniques than paper. Their runnability on printing machines is difficult due to static electricity, leading to lower speed operation. The ability of the ink to dry on plastic film is much lower than on paper, due to the lack of porosity of films. This also impacts negatively the operation speeds. The adhesion of inks and therefore the resistance to set off, scratch and rub are lower on plastic films, due to the lack of porosity and the lower surface energy.

Plastic films show significant restrictions on adhesion to polymers of other chemical nature. As examples, polyester (in particular polyethylene terephthalate, PET), which is commonly used in the flexible printed electronic industry, has a poor affinity with polyamide (PA) and polyolefins (polypropylene, polyethylene). Polyolefins have a poor affinity with most of the common polymers used in the plastic industry. This limitation would mean that in most cases, it would be necessary to use as the base substrate for the label a film made of the same polymer as the one used for the final plastic piece. To overcome this critical drawback when producing the product, it is necessary to insert an adhesion medium between the two surfaces. This can be done either by coinjection, coextrusion, hot melt bonding, adhesion primer coating or any other means known by the expert. But these technical operations can be complex, are time consuming, lead to production waste and finally significantly increase the overall process cost. Moreover, polymers tend to have different thermal expansion coefficients, which lead to lack of adhesion or even separation of polymer complex or sandwich on cooling after production of the plastic piece.

Paper has been used as a laminate for décor applications for many years. Thanks to the porous networks of cellulose fibers and their affinity to resins, one or more sheets of papers are accordingly saturated with a resin and glued together under heat and pressure to form a monolithic structure. The laminated paper product is robust, rigid, resistant to scratches, dirt, and water, and can be decorated. Applications of paper laminate include flooring, decorative interior, exterior panels, roofing, etc.

The present application aims to leverage some of the unique features of paper, in particular its porosity and its affinity to resins, to open up new application fields including the production of electronic devices and products comprising such devices embedded or integrated therein.

### Summary of the invention

The invention relates to a paper-based printed electronic device according to claim 1. A fully encapsulated electronic device is obtained which is protected against external environmental and physical damages such as against moisture and oxygen and has acquired sufficient resistance to tearing. The impregnated and encapsulated electronic device can then be successfully integrated into an object in a form of a flat or curved monolithic structure. This may especially be achieved through a lamination process, as said device sustains high pressure, high temperature, does not create bubbles, does not delaminate, and can be fully embedded into an end product.

It has been observed by the inventors that by contrast to the results obtained with laminates using plastics as substrate for the electronic device, using paper sheets as functional sheets in the electronic device does not provide fragility to the laminated product when such device is integrated into said laminated product which is finally obtained when carrying out the lamination process. In particular, with such laminated paper sheets used as substrate for the electronic device no delamination of the laminate has been observed and the strength of the produced laminate is similar to that of plastic-based laminates.

It has been observed that the impregnated resin remains stable and does not damage the circuitry comprising both a printed ink portion and other electronic components such as silicon components. Furthermore, by replacing the water trapped within papers, with a resin, drawbacks related to the water contents in the paper are reduced..

The invention also relates to a process or method for producing an electronic device according to claim 14.

### Detailed description of the invention

The terms "trace", "pattern", and "layer" are used herein as nouns with their usual meanings in the field of printed electronics, i.e. "trace" designates any visible deposition of a printed ink, "pattern" designates any continuous or consistent arrangement of a printed ink, and "layer" designates a printed portion of an ink covering a wider or the entire surface area of a sheet. Accordingly "trace", "pattern", and "layer" elements are electronic components which are, individually or when connected to each other and/or to further components, functional electronic components. Said functionality is maintained after the printed and assembled device is impregnated and encapsulated with the resin.

An "electronic ink" refers in the context of the present invention to inks conventionally used in the field of printed electronics, and is readily identifiable by a skilled person. In particular, an electronic ink has suitable electric and/or electronic properties, in particular conductance, resistance, and/or impedance properties and/or dielectric, semiconducting, photovoltaic and/or electroluminescent properties. Electronic inks comprise organic and inorganic inks. Organic inks comprise conductive polymers, polymer semiconductors, in particular conjugated polymers. Inorganic inks comprise in particular dispersions of metallic or semiconducting particles, in particular micro and nanoparticles, in particular silver and/or gold particles and/or particles comprising silicon or oxide semiconductors. Examples of such inks will be described in the following sections.

In a particular embodiment, at least two sheets of the plurality of the sheets are paper substrates comprising printed traces, patterns, and/or layers of an electronic ink.

In a particular embodiment the at least one paper sheet comprises printed one or more traces, patterns, and/or layers of a conductive ink

In a further embodiment, at least one paper sheet comprises printed one or more traces, patterns, and/or layers of a semiconductive ink or a dielectric ink.

In another embodiment, at least one paper sheet comprises one or more types of electronic ink, in particular of conductive inks, semiconductive inks, and/or dielectric inks.

As disclosed herein, the term "conductive ink" encompasses materials possessing electrically conductive properties having a viscosity suitable to be printed by a printing method known to a skilled person. In particular, a conductive ink may comprise electrically conductive materials diluted or suspended in a solvent, which evaporates or solidifies upon curing or annealing so that the electrically conductive materials come in contact to allow electrical conductivity. The electrically conductive materials include inorganic and organic materials. Inorganic materials comprise metal particles, in particular microparticles or nanoparticles, in particular silver, copper and/or gold particles. Organic materials comprise conductive polymers. In a particular embodiment, the electrically conductive materials are microparticles or nanoparticles of silver, carbon, carbon nanotubes, silver chloride, or polyaniline (PAni).

The term "semiconductive ink" encompasses materials possessing electrically semiconductive properties having a viscosity suitable to be printed by a printing method known to a skilled person. In particular, a semiconductive ink may comprise semiconducting materials diluted or suspended in a solvent, which evaporate or solidifies upon curing or annealing so that the semiconducting materials come in contact to exhibit semiconducting properties. The semiconducting materials include inorganic and organic materials. Inorganic materials comprise semiconducting particles, in particular microparticles or nanoparticles, in particular particles comprising silicon or oxide semiconductors. Organic materials comprise polymer semiconductors, in particular conjugated polymers. In a particular embodiment, the semiconducting material includes poly-3-alkylthiophene (P3AT), and/or polyvinyledenedifluoride-tetrafluoroethylene (PVDF-TrFE).

The term "dielectric ink" encompasses materials possessing electrically non-conductive, insulating, or very poorly conductive properties having a viscosity suitable to be printed by a printing method known to a skilled person. In particular, a dielectric ink may comprise dielectric materials diluted or suspended in a solvent, which evaporate or solidifies upon curing or annealing. The dielectric materials include inorganic and organic materials. In a particular embodiment, dielectric material is polyhydroxystyrene (PHS).

Acccording to the invention, a printed paper sheet comprises one or more traces, patterns, and/or layers of electronic ink, in particular conductive inks, and/or semiconductive inks, and/or dielectric inks overlapping in various arrangements. For example, any one of conductive ink, semiconductive ink, and/or dielectric ink can be printed on a paper sheet. After curing (or sintering) the printed ink, any one of said inks can be printed on top of the previously printed and cured ink. This over-printing process can be repeated at least once and provides overlapping arrangements.

In a particular embodiment, the plurality of sheets comprising printed traces, patterns, and/or layers of electronic inks, in particular conductive inks, and/or semiconductive inks, and/or dielectric inks are aligned perpendicularly to the plane of the sheets in a way to ensure electrical continuity and/or to form a functional electronic device.

According to the invention, the electronic device comprises a sheet wherein the sheet is appended with a plurality of not-printed electronic components chosen from a resistor, a capacitor, a diode, an inductor, a transistor, an electrode, an integrated circuit (IC), a switch, a piezoelectric device, an antenna, a battery, and, a transducer, a logic gate, a sensor or a wire and wherein the electronic components are connected together to create an electronic circuitry.

Any of the thus defined embodiments of the electronic device may further include one or more additional electronic components which are printed.

In a particular embodiment, one or more discrete rigid electronic components are appended, in particular soldered or glued, to at least one sheet of the plurality of sheets, for example using pick and place. In particular embodiments, such non-printed components include a silicon based chip, in particular a chip forming part of an RFID transponder, and/or a diode, such as an LED, a resistor, a capacitor, an inductor, a transistor, a switch, a piezoelectric device, an antenna, a battery, a transducer, a logic gate, and/or a wire, such as a copper wire. In particular embodiments, the printed electronic circuit comprises essentially all the wiring of the circuit. particular embodiment, at least one sheet comprises a printed electrode or is an electrode. In a particular embodiment, said electronic components are printed with electronic ink, in particular conductive, semiconductive, and/or dielectric inks. In a further embodiment, the electronic components comprise non-printed rigid components.

The electronic components are connected together to create an electronic circuitry, for example by printing with one or more conductive inks and/or by wiring.

In a particular embodiment, the electronic components of the electronic device are all provided on at least one, in particular more than one sheet of paper.

In a preferred embodiment, each sheet in the plurality of sheets comprised in the electronic device is a sheet of paper.

In a particular embodiment, the electronic device, after printing and before being impregnated and encapsulated with a resin is made of paper sheets only and comprises more than 2, in particular up to 100 and especially from 1 or from 2 to 100, from 1 or from 2 to 50 or from 10 to 100 or from 10 to 50 sheets of paper. In a particular embodiment, the electronic device comprises 1, 2, 3, 4, 5, 6, 7, 8, 9 or 10 sheets of paper, especially of paper with electronic components.

The paper sheets of the electronic device may all be of the same type or alternatively may encompass different types of papers. In particular, the paper sheets intended for the printing or deposit of the electronic components may be of specific type(s) (such as disclosed hereafter) whereas additional sheets such as support sheets may be of a different type. As an example Kraft paper may be used as a support sheet to receive the paper sheets comprising the electronic components. A decor paper sheet or a tracing paper sheet may form the top sheet of the device. In a particular embodiment, the electronic device comprises one or more sheets of materials other than paper, such as glass fiber, carbon fiber, and plastic films.

In a particular embodiment, the electronic device comprises multiple sheets of paper wherein at least one sheet of paper is Kraft paper intended as a support or bottom sheet, and a decor paper or a tracing paper as a top sheet of the device, and one or more than one sheets of a coated paper receiving the electronic components;. in particular the electronic component(s), in particular those which are printed with suitable ink, are printed on a coated paper selected for its ability as a support for said specific printing and for its ability to impregnation and encapsulation by resin after the printing step has taken place.

This paper intended for printing is thus selected for its properties to fulfill requirements related to temperature resistance, bulk porosity, surface smoothness, printing ability with the specific inks (functional inks) disclosed herein.

It is indicated that an advantage of the invention is to provide an electronic device wherein the various sheets that it encompasses do not need to be glued or bonded to their respective contiguous sheet(s) by an adhesive layer.

Paper suitable for electronics printing have been disclosed in the art and in particular in patent applications published as WO 2013/104520 and WO 2015/059157. Such papers as disclosed in WO 2013/104520 are characterized as very smooth papers with a roughness Ra in the range 1 to 30 nm, for example, which means that an electronically functional (e.g. conductive, semiconductive or dielectric) sheet can be produced by printing a layer of ink which is very thin. Alternatively, in order to enable inks that may be cheaper or in order to enable deposit of thicker layers of ink it may not be necessary to use a support with a side intended for printing that has to be as smooth as above stated. Accordingly, WO 2015/059157 discloses a paper comprising a side with a roughness Ra which is, for example, in the range 0.1 to 3 µm and could be sufficient to produce high quality electroconductive sheets. Both types of papers having different smoothness have also different microporosity which may influence the adhesion of the ink to the surface and which may impact their impregnation by the resin.

Papers suitable to carry out the present invention such as those described in the above patent applications and having the above disclosed features are papers which can act as a support for a trace, pattern or layer of conductive, semiconductive or dielectric ink deposited or in particular printed, and which is thermally resistant (low deformation or low dimensional shrinkage at high temperature, low yellowing effect) and as a consequence can be used to produce conductive tracks with good conductivity (in particular due to the relatively low porosity and/or low roughness of the surface of the paper which is to be printed). Such papers have also revealed suitable for resin impregnation according to the present invention after for deposition or printing of electronics components to enable production of a functional electronic device.

In particular embodiments, the paper substrate which harbours the electronic components is a coated paper substrate, wherein such coating is suitable for printing with electronic inks (conductive, semiconductive or dielectric ink) and in particular wherein such coating comprises pigments and a binder or a mixture of binders. Papers disclosed in WO 2013/104520 and WO 2015/059157 are coated papers suitable for printing with conductive, semiconductive or dielectric ink. They may be used in combination to produce the electronic device especially when some electronic components are better suited for printing or deposit on a very smooth or to the contrary on a less smooth paper (such as electrodes).

In particular embodiments of any of the above embodiments, the paper substrate comprises at 70 to 90 % of short cellulosic fibers by dry weight. In particular embodiments, the coating comprises a binder with a glass transition temperature lower than 20 °C, or event lower than 10°C preferably and said coating comprises 5 to 50 parts by dry weight of such binder. In particular embodiments, the paper substrate has an ISO brightness and/or a D65 brightness in the range 70 to 90, preferably 75 to 85 and/or the difference in ISO brightness and/or D65 brightness before and after exposing the paper substrate to heat during 5 min at 180 °C is equal to or less than 3.

In a particular embodiment, the paper substrate is very smooth as disclosed in WO 2013/104520 (including Powercoat^{®}HD) and has a Bekk smoothness equal to or higher than 900 s, preferably equal to or higher than 2000 s. In particular embodiments, the paper substrate has a gloss at 75 ° equal to or higher than 70 %, preferably equal to or higher than 80 %. In such a case, the binder combined with the pigments for coating the paper substrate may in particular be chosen among acrylic polymer, polyurethane, polymethyl methacrylate, styrene butadiene, vinyl acetate, polyamide, nitrocellulose or any other cellulose, polyvinyl alcohol, starch or a mixture thereof.

In a particular embodiment (as disclosed in WO 2015/059157), where the paper (Powercoat^{®}XD) is not as smooth as disclosed in WO 2013/104520, when producing said paper, the binder or binders layer deposited onto the surface of the paper and intended to be printed a low glass transition temperature, in particular 20°C or less, preferably 10°C or less, which means that the thermal resistance of the paper can be considerably improved, in particular in terms of deformation and said layer comprises 10 to 30 parts dry weight of binder with a glass transition temperature of 20°C or less, preferably 15 to 25 parts dry weight, more preferably 19 parts dry weight. Preferably, an acrylic binder is used. In a particular embodiment of such paper, said layer may comprise 0.05 to 15 parts dry weight of viscosifying agent, more preferably 0.05 to 5 parts dry weight, and still more preferably 0.05 to 4 parts dry weight of such an agent. In particular, said layer may comprise 5 to 10 parts dry weight of polyvinyl alcohol used as a viscosifying agent, more preferably 8 parts dry weight.

The binder used to prepare the coating of the coated paper suitable for use according to the invention may be selected from acrylic polymer, polyurethane, polymethyl methacrylate, styrene butadiene, vinyl acetate, polyamide, nitrocellulose or any other cellulose, polyvinyl alcohol, starch and a mixture thereof.

In particular embodiments of any of the above embodiments, the paper substrate is selected among Powercoat^{®} HD and Powercoat^{®} XD papers (Powercoat is a trademark of Arjowiggins).

In a particular embodiment of the invention, no glue or adhesive is used to assemble the sheets and in particular between the sheets harbouring electronic components for the preparation of the electronic device The invention accordingly concerns the use of coated papers such as Powercoat^{®} HD and Powercoat^{®} XD papers in the preparation of an electronic device which is impregnated and encapsulated in resin.

The resin with which the electronic device is impregnated and encapsulated may be selected among resins including urea formaldehydes (UF), melamine formaldehyde (MF), urea-melamine-formaldehyde (UMF), acrylic, phenolic, polyester, epoxy resins or mixtures thereof.

Also, the resin may be a thermoset resin, and in particular it may be selected among polyurethane, melamine, epoxy, polyesters, rubber and the like polyolefines, acrylic-acid ester polymers (homopolymers or copolymers), vinylpolymers, polyamides, polyesters, polyacetals and polycarbonates.

According to an embodiment, the resin may comprise further components or molecules, such as inorganic and/or organic components, in the form of chemicals, fillers, or solvents.

Once impregnated, the resin replaces water molecules within the pores of paper, and depending on the type of chemicals, fillers or solvents contained in the resin, the properties of paper may be modified. These properties include fire resistance, thermal conductivity for heatsinking, magnetic shielding, or even electrical conductivity between two sheets or layers of said papers.

The choice of the resin may depend upon the porosity of the paper to accept the proper amount of resin. During the impregnation step the resin penetrates into the pores of the paper including advantageously by migrating from one side to the other side of the paper. When the conditions for impregnation (in particular, the quantity of resin provided is adapted) and the porosity of the paper allows it, the resin may saturate the paper thereby displacing essentially all air from the pores of the paper. In a further step encapsulation of the device with the resin is achieved as a coating of all faces of the device with resin. When impregnation and encapsulation treatment has been performed, the device is dried and is then ready for lamination.

The resin is provided in a liquid state or as a dry "film". During the impregnation process, the viscosity of the resin becomes low enough to penetrate into the pores of paper.

Impregnation and encapsulation are carried out in accordance with methods known from the person skilled in the art (i.e. where paper or other types of sheets are pre-impregnated) in order to achieve an electronic device which is protected from moisture and oxygen and where necessary from grease. Accordingly the sheets of the assembled device are coated, either individually before their assembly or after they have been assembled, with a resin in conditions enabling the pores of the sheets to be filled with the resin and all the surfaces of the sheet(s) to be coated. The impregnation may enable saturation of the pores of the sheets, or at least saturation of the pores the most external sheets of the electronic devices, at least of a number of sheets sufficient to enable the moisture and oxygen barrier to be formed for the assembled electronic device. The coating of the top, bottom and lateral surfaces of the electronic device with the resin also provides the barrier sought and is carried out in a way that avoids surface defects.

According to an embodiment, at least one sheet of the plurality of sheets is provided as a pre-impregnated sheet with a resin for the assembly of the sheets in the device.

Impregnation and encapsulation may be carried out using rollers: the assembled sheets of the electronic device are accordingly provided on a pre-wetting roller which is partly in contact with a bath containing the liquid resin. The resin is provided on the roller as a film and is transferred to the side of the bottom side of the paper in conditions enabling resin to penetrate into the pores of the paper and when the paper circulated over further rollers the resin is allowed to migrate toward the other side of the paper. Where necessary, the paper may further be immersed in a bath of resin to ensure the coating of the top surface (where electronic components are printed/appended or bare) of the paper. The process is performed in such a way that the air and the water contained in the paper are displaced by the resin until advantageously saturation of the pores of the paper. The final stage of the resin impregnation comprises a drying step in order to remove the water and/or solvent(s) contained in the provided resin, from the sheet(s). The paper impregnated with resin and/or pressed at high temperature becomes transparent or translucent as the cellulose of paper and the impregnation resin have about the same refractive index.

After the electronic device has been impregnated and encapsulated with resin it may be laminated, either as such or in an object or a product.

The lamination may be achieved using a known press under pressure and heat as disclosed in the present application. During lamination, final curing of the resin may take place. The resin is then a cross linked thermo-set material. The lamination steps may be performed to achieve the monolithic structure of the electronic device. Alternatively, it may be performed when the electronic device is integrated or embedded in an object.

It has been surprisingly observed that the paper used for electronics printing such as Powercoat^{®} HD which is a very smooth paper having low porosity despite enables good impregnation with resin. When smoothness of the level of the smoothness achieved with Powercoat HD paper is not an absolute requirement to build the electronic circuitry, paper such as Powercoat XD may be chosen for the production of the electronic device, especially for its impregnation ability.

The electronic device disclosed herein may be, but is not limited to, a near field communication (NFC) device, a radio frequency identification (RFID) device, a photovoltaic cell, an emissive display, an energy harvesting device, a loudspeaker, or a multi-layer printed circuit board (PBC).

In a particular embodiment, the electronic device is integrated into an object. In particular, the electronic device is embedded in an object which comprises materials compatible to be laminated with the resin with which the electronic device is impregnated and encapsulated. In such a case the object is produced after the electronic device has been assembled, impregnated and encapsulated with the resin.

In a particular embodiment, the electronic device is integrated into the structure of a manufactured product. In particular, the electronic device is embedded in the structure of the product during its manufacturing. In a particular embodiment, the manufactured product is of the following categories: consumer durables, interior or exterior finish, building envelope, or transport vehicles such as cars, trains, boats, planes or the like.

The electronic device is described to be "integrated" into an object or the structure of a manufactured product since the electronic device is not separable from the object or the structure of a manufactured product once integrated, and provides added electronic function while preserving the normal function of the object and without disturbing the structure of the manufactured product.

The electronic device is described to be "embedded" in said object or the structure of a manufactured product since it is strongly and seamlessly bound to the object or the structure of a manufactured product, for example, inside the object or the structure of the manufactured product.

The final form of the electronic device may be flat or curved depending on the shape of the object or the structure of a manufactured product. The electronic device is said to be of "monolithic structure" since the plurality of sheets is strongly bound to form one piece from which each sheet cannot be physically taken apart from the monolithic structure.

The invention also relates to a method for producing an electronic device according to claim 14.

The method of producing the electronic devices includes a step of appending one or more electronic components which are not-printed and in particular are rigid components (examples thereof have been given herein). This step is carried out before the impregnation and encapsulation of the device or sheets.

According to this process, the step of resin impregnation and encapsulation of each sheet (or of subsets of sheets) with or without printed electronic inks, printed and/or non-printed electronic components is carried out optionally, prior to assembling the plurality of sheets in a direction perpendicular to the plane of the sheets. In one embodiment, when each sheet is impregnated and encapsulated with resin in step (ii), the assembly of the plurality of sheets may be encapsulated again in step (iv). In another embodiment, when each sheet is impregnated and encapsulated with resin in step (ii), the resin encapsulation of the assembly of the plurality of sheets in step (iv) may be skipped. In a particular embodiment the sheets, and in particular the paper sheets are individually provided as sheets pre-impregnated with resin, for the preparation of the electronic device.

In a particular embodiment, the step (i) comprises a step of printing at least one sheet with one or more traces, patterns, and/or layers of conductive ink, and/or one or more traces, patterns, and/or layers of semiconductive ink, and/or one or more traces, patterns, and/or layers of dielectric ink. Any suitable printing technology may be used such as inkjet printing, offset printing, gravure printing, screen printing, flexography, and/or electrophotography.

In a particular embodiment, the electronic device, in particular the printed electronic circuit or ink deposits, are not thicker than 200 µm, preferably not thicker than 50 µm, preferably not thicker than 20 µm. Typically, the thickness of electronic ink printing is in the order of magnitude of 10 to 20 µm for screen printing, 2 to 3 µm for flexography and around 0.3 µm for inkjet.

The method of invention preferably further comprises a step of curing or sintering the conductive and/or semiconductive and/or dielectric ink, following the ink printing step. Once the inks are applied and dried if necessary, a step of curing or sintering by thermal annealing, photonic curing, or ultraviolet (UV)-radiation annealing takes place, in order to sinter the small particles in the ink and achieve or improve electronic properties. As an example, for conductive inks, small metal particles are included in the ink that need to be, at least partly, melted or sintered in order to increase the electric conductivity significantly. Compared with commonly used plastic films used in printed electronics applications, such as PET, these papers provide a much better thermal resistance and can be sintered at much higher temperatures, for example at 200 °C, compared to a maximum of 120 °C to 140 °C for PET. In particular cases, this leads to much better electric/electronic properties with the same amount of ink deposit or allows using much less ink in the deposit to achieve the same electric/electronic properties. This is a very significant advantage with some inks, especially conductive inks, made of expensive raw materials such as silver nanometric powder.

The resin impregnation and encapsulation may be carried out by applying a resin at size press on a paper machine, by placing the paper sheet to be impregnated and encapsulated in a dip pan, or by any other method in order to fill or saturate the pores of the paper sheet as well as to coat the surface of the paper sheet. The final stage of the impregnation and encapsulation step comprises a drying step to remove any water or solvent from the resin (i.e. wet resin) in the paper, and/or a step of partially curing or partially solidifying the resin.

The resin used in the process as disclosed herein impregnates and encapsulates a paper sheet or the assembly of the sheets in the electronic device, in such a way that the percentage weight change after the step of resin impregnation and encapsulation is in the range of 20 to 90 %. The percentage weight change is determined by finding the difference between the weight of a paper sheet or the assembly of the sheets with or without electronic components (printed or non-printed portion) just before the step of resin impregnation (and encapsulation) and the weight of the same after the step of resin impregnation (and encapsulation).

In a particular embodiment when the electronic device is as such laminated or laminated in an object or a manufactured product, the lamination step may be carried out under a pressure in the range of 20 to 100 bars and a temperature in the range of 120 to 200 °C for a duration of 15 seconds to 90 minutes.

For example, for low pressure lamination process (LPL), a pressure in the range of 20 to 30 bars is applied at a temperature range in the range of 150 to 180 °C for a duration of 15 to 150 seconds. In a particular embodiment, the low pressure lamination process is carried out at 180 °C with an applied pressure of 20 bars for 1 minute.

For example, for high pressure lamination process (HPL), a pressure in the range of 40 to 100 bars is applied at a temperature in the range of 120 to 180 °C for a duration of 30 to 60 minutes. In a particular embodiment, the high pressure lamination process is carried out at 160 °C with an applied pressure of 60 bars for 30 minutes.

Lamination is carried out by pressing two or more resin impregnated and encapsulated sheets together by applying heat and pressure simultaneously for a given duration of time. The lamination may be carried out to produce objects in flat or non-flat form.

In a low pressure lamination process, papers typically of melamine impregnated decorative paper are pressed at pressures of about 20 to 30 bars and at about 150 to 200 °C (according to procedures such as disclosed in plastic laminate symposium, August 17-20, 1998).

In a high pressure lamination process, high pressure laminate comprising several layers of resin impregnated papers are pressed at pressures exceeding 50 bars and temperatures greater than 125 °C (according to procedures such as disclosed in plastic laminate symposium, August 17-20, 1998).

The invention also concerns an electronic device for use in the manufacture of an object or product. In a particular embodiment, the electronic device may be integrated into said object or manufactured product during its manufacturing by the lamination process disclosed above. The object is or is a part of the following categories: consumer durables, interior or exterior finish, building envelope, or transport vehicles such as cars, trains, boats, planes or the like.

Accordingly the monolithic structure of the electronic device may be obtained when the impregnated and encapsulated device is integrated or embedded in an object or product through a lamination process.

Particular features of the invention will be illustrated in the examples which follow and in the accompanying drawings. The features disclosed in respect of these examples also define embodiments of the invention described above and accordingly may be specified in combinations with these embodiments.

### Brief Description of the drawings:

Figure 1: assembly of layers and sheets in an electronic device for photovoltaic application
Figure 2: assembly of layers and sheets in an electronic device for emissive display application
Figure 3: assembly of layers and sheets in an electronic device for energy harvesting application
Figure 4: assembly of layers and sheets in an electronic device for loudspeaker application
Figure 5: multilayer printed circuit board replacement

### Examples

The inventors have provided illustration of devices encompassing Printed Electronics Circuitries on paper with improved properties accordingly overcoming shortcomings inherent to untreated paper which may remain physically fragile and tearable. These devices also solve the problem of devices built on paper that are not a self-sustainable structure, in particular when paper of low grammage is used. Accordingly it is generally considered that printed electronics circuitry on non-treated paper needs to be glued or embedded onto a support / product as a label or an inlay. Additionally, paper on its own contains 5 % water, and is a poor barrier to water, grease or oxygen. Many applications are beyond the capabilities of Printed Electronics on paper in such conditions.

The inventors have provided improved solution by proposing an electronic device which involves impregnation and encapsulation of the paper sheets that it contains, including of the functionalized paper sheets after printing or depositing electronic components, with a resin. Accordingly the obtained structure although a monolith (as a result of assembly of sheets and final lamination) exhibits sufficient bending stiffness and resistance and also enables providing a barrier, in particular to moisture (water) and oxygen and optionally to grease.

The combination of resin use and laminates approach which is provided according to the invention to produce the electronic device is opening wide applications including due to its ability to provide combination of sheets (or layers) in the z-direction (perpendicular to the plane of the sheets), thereby enabling the piling up of layers of circuitries or active electronics components and their supply as a monolithic structure or laminate wherein the circuitry and more generally the electronic components are embedded. The electronic components are said to be "embedded" since the various sheets of the electronic device are strongly bound to each other and therefore may be considered to be an integral part of a monolithic or laminate structure.

At the end of the resin impregnation, encapsulation and lamination (enabling curing of the resin), the end product would be waterproof, oxygenproof and also greaseproof in a very integrated manner.

Printing of electronics component can be carried out on paper substrate using a flat screen, rotary screen, flexographic, or inkjet printer using commercial silver- based inks (or other inks comprising metal particles) and then sintered by high temperature IR (150-180°C), thermal annealing, or photonic curing and non-conductive heat or UV-cured dielectric inks for circuitry insulation and cross-over bridges.

In order to integrate the electronic device into a product such as a paper (e.g. for the manufacture of functionalized end products such as functionalized wallpaper, especially obtained by lamination with the electronic device) a known roll-to-roll manufacturing process may be used.

In the following Examples the papers used to print or to deposit the functional electronic traces, patterns and/or layers are papers produced according to WO 2013/104520 or to WO 2015/059157 or accordingly are papers commercialized under the trademarks Powercoat^{®}HD or Powercoat^{®}XD respectively.

### Example 1: photovoltaic application (illustrative example not belonging to the invention as claimed)

Using paper in a photovoltaic application would be considered very challenging for various reasons:
- Photovoltaic (PV) materials, in particular the organic printable ones, tend to be very sensitive to oxygen and water. Accordingly, excellent barrier is required.
- Most applications of PV are outdoor which may be regarded as not compatible with paper use due to its sensitivity to moisture.

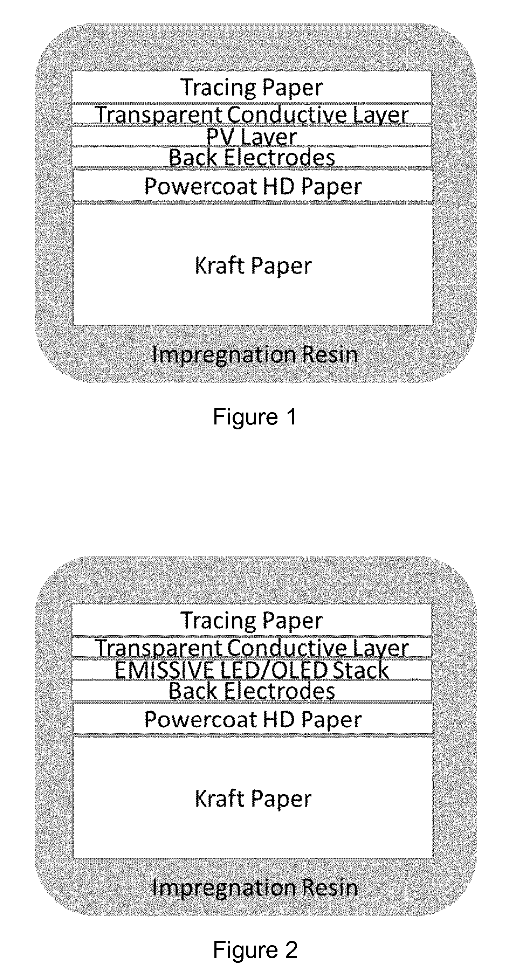

It was however possible to conceive a suitable photovoltaic device (Figure 1) using paper as a substrate to embed electrodes, PV layer and back printed electrode in a sandwich impregnated and encapsulated with resin. The arranged layers i.e., transparent conductive layer, PV layer, printed layer forming back electrode were provided on a sheet of support paper which was applied on a Kraft paper sheet. A transparent sheet of tracing paper may also be added on top of the functional sheet obtained after deposit or printing of the electronic components. Alternatively, the transparent conductive layer may be deposited or printed on the tracing paper rather than overlapping with the other electronic components. A Kraft paper sheet is used as a balancing layer at the bottom of the device and it accordingly stabilizes the device. The process of producing a solar cell is as follows:
1/ Printing the different layers on Powercoat HD paper with a screen printing machine, in an inert gas atmosphere:
   - First layer is an electrode printed with Orgacon silver ink SI-P1000X from Agfa, 3 µm in thickness.
   - Second layer is the PV layer printed with lisicon^{®} PV-D series/ lisicon^{®} PV-A series blend as an active layer (200nm) from Merk
   - Third layer is a second electrode printed with Pedot/PSS EL-P5015 from Agfa, 400 nm in thickness
2/ Impregnating the paper in step 1 with a solvent-base MF resin
3/ Impregnating a tracing paper with a solvent-based MF resin
4/ Pressing the different layers of paper, together with a Phenolic pre-impregnated kraft paper in a HPL process (160°C, 60 bars, 30 minutes).

The solar cell made by this method showed a Power Conversion Efficiency of 5 % for 6 month at 23°C and 50 % humidity.

### Example 2: emissive display application (illustrative example not belonging to the invention as claimed)

Using paper in a display application would be considered very challenging for various reasons:
- Display material, in particular the organic printable ones, tend to be very sensitive to water and oxygen. Accordingly, excellent barrier is required.
- Most applications of displays are mobile, handheld and require rugged and robust solutions which may be regarded as incompatible with paper solution due to its fragility.

Using various sheets of specialty paper it was possible to conceive a display (Figure 2) using paper as a substrate to embed top transparent electrodes, a display stack (that may be emissive LED or OLED stack) and back printed electrode in a sandwich impregnated and encapsulated with resin. The arranged layers i.e., were provided on a sheet of support paper which was applied on a Kraft paper sheet. Alternatively, the transparent conductive layer may be deposited or printed on the tracing paper rather than overlapping with the other electronic components. The process of producing a light emitting diode stack is as follows:
1/ Printing the different layers on Powercoat HD paper with a screen printing machine, in an inert gas atmosphere:
   - First layer is an electrode printed with Orgacon silver ink SI-P1000X from Agfa, 3 µm in thickness.
   - Second layer is the OLED layer printed with livilux^{®} OLED series as an active layer (200nm) from Merk
   - Third layer is a second electrode printed with Pedot/PSS EL-P5015 from Agfa, 400 nm in thickness
2/ Impregnating the previous paper with a solvent-base MF resin
3/ Impregnating a tracing paper with a solvent-based MF resin
4/ Pressing the different layers of paper, together with a Phenolic pre-impregnated kraft paper in a HPL process (160°C, 60 bars, 30 minutes).

OLED constructed by this process showed a working yield of 90 % for 2 month at 23°C and 50 % humidity.

### Example 3: energy harvesting application (illustrative example not belonging to the invention as claimed)

Using paper in an energy harvesting application would be considered very challenging for various reasons:
- Piezo materials, in particular the organic printable ones, tend to be very sensitive to water. Accordingly, excellent barrier is required.
- Most applications of energy harvesting is flooring or outdoor which may be regarded as not compatible with paper use due to its sensitivity to moisture, its rugged requirement, scratch resistance, etc...

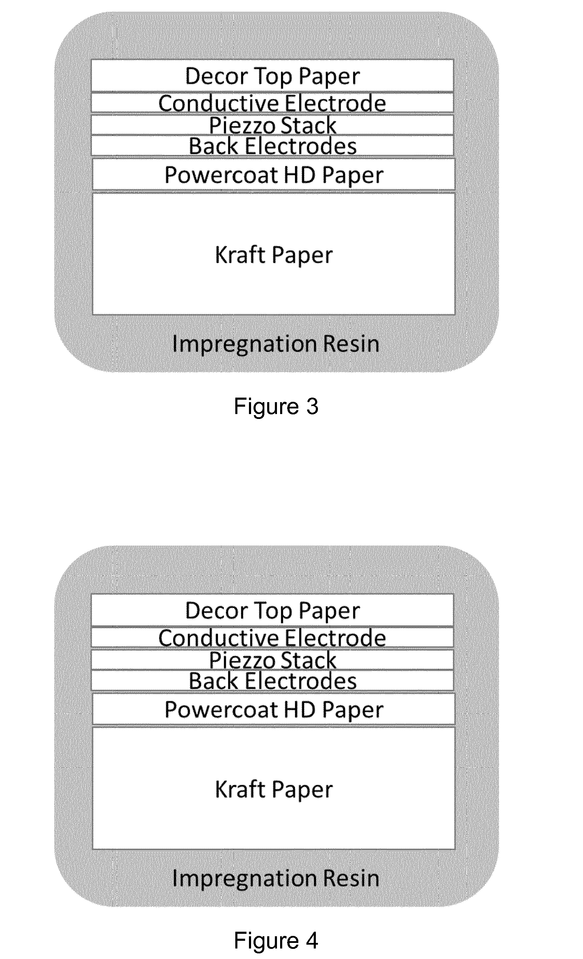

Using various sheets of specialty paper it was possible to conceive a display (Figure 3) using paper as a substrate to embed top décor paper, printed electrodes, piezo layer and back printed electrode in a sandwich impregnated and encapsulated with resin. The arranged layers i.e., were provided on a sheet of support paper which was applied on a Kraft paper sheet. On the support sheet rendered functional with the electronic components, a transparent sheet of tracing paper may be added. Alternatively, the conductive electrode may be deposited or printed as a layer on the décor paper rather than overlapping with the other electronic components. The process of producing an energy harvesting device is as follows:
1/ Printing the different layers on Powercoat HD paper with a screen printing machine:
   - First layer is an electrode printed with Orgacon silver ink SI-P1000X from Agfa, 3 µm in thickness.
   - Second layer is the Piezzo layer printed with Piezotech^{®} FC25 ink P from Piezzotech ARKEMA, 4 µm in thickness
   - Third layer is printed with Orgacon silver ink SI-P1000X from Agfa, 3 µm in thickness.
2/ Poling the devices under 200 v (5 cycles).
3/ Impregnating the previous paper with an aqueous-base MF resin
4/ Impregnating a decor paper with an aqueous-based MF resin
5/ Pressing the different layers of paper, together with Phenolic pre-impregnated kraft paper with an HPL process (160°C, 60 bars, 30 minutes).

When a pressure of 2 bars is applied to the system, a current of is generated from the device.

### Example 4 : loudspeaker application (illustrative example not belonging to the invention as claimed)

The structure of the loudspeaker is exactly the same as the energy harvesting device in Example 3. In case of an energy harvesting device, vibrations as an energy source generate electricity, whereas in case of a loudspeaker, electricity generates vibrations. The process of producing a loudspeaker is as follows:
1/ Printing the different layers on Powercoat HD paper with a screen printing machine :
   - First layer is an electrode printed with Orgacon silver ink SI-P1000X from Agfa, 3 µm in thickness.
   - Second layer is the Piezzo layer printed with Piezotech^{®} FC25 ink P from Piezzotech ARKEMA, 4 µm in thickness
   - Third layer is printed with Orgacon silver ink SI-P1000X from Agfa, 3 µm in thickness.
2/ poling the devices under 200 v
3/ Impregnating the previous paper with an aqueous-base MF resin
4/ Impregnating a decor paper with an aqueous-based MF resin
5/ Press the different layers of papers, including also Phenolic pre-impregnated kraft paper with an HPL process (160°C, 60 bars, 30 minutes).

When an alternative tension of 24 V is applied to the loudspeaker, sound is generated by the device.

### Example 5 : multi-layer printed circuit board( PCB) replacement (illustrative example not belonging to the invention as claimed)

Printed circuit board (PCB) is usually made of Epoxy Resin and FiberGlass. In the art, it was known to perform resin impregnation and lamination of layers of pre-impregnated fabrics or Kraft paper with copper metal foils to enable a succession of conductive circuitries. In such devices, discrete components were however soldered on top/bottom of the PCB. Air was used to cool the electronics down (thermal sink).

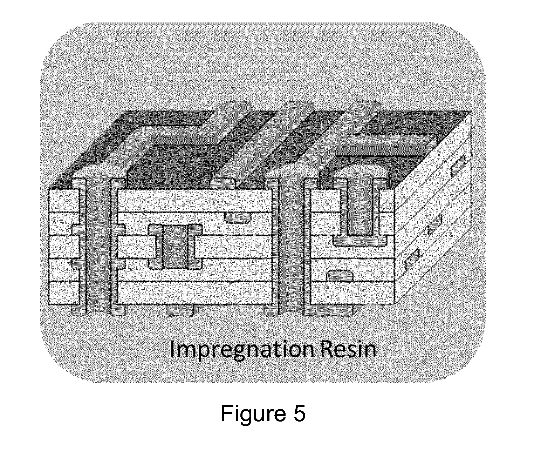

Printed Electronics Circuitry on Paper (figure 5) may be complex to handle, in particular when connecting to the external world is at stake. The solution provided by the invention enables Printed Electronics Papers assembly together in the z-direction, and the subsequent impregnation step with resin enables providing a rigid structure that can be easily connected.

In this device, resin encapsulates sensitive components or chemicals to protect them from oxygen and water or moisture. It also has a structural role to hold connector and reduce fragility in a protective monolithic structure wherein the circuitry and components are embedded. Additionally key issue is the assembly mode that enables creating vias that are well aligned to enable circuitry continuity between the layers.

The process of producing a multi-layer printed circuit board (PCB) replacement is as follows:
1/ Printing the first circuitry on Powercoat XD paper with a screen printing machine:
   - First circuitry layer printed with an Orgacon silver ink SI-P1000X from Agfa, 3 µm in thickness.
   - holes drilled with a laser
   - Via printed with an Orgacon silver ink SI-P1000X from Agfa,
2/ Printing the second circuitry on Powercoat XD paper with a screen printing machine:
   - First circuitry layer printed with an Orgacon silver ink SI-P1000X from Agfa, 3 µm in thickness.
   - holes drilled with a laser (3 mm in diameter)
   - Via printed with an Orgacon silver ink SI-P1000X from Agfa,
3/ Impregnating the previous papers with an aqueous base MF resin
4/ Alining the 2 layers with the via holes
5/ Pressing the different layers of papers, together with Phenolic pre-impregnated kraft paper with an LPL process (180°C, 20 bars, 1 minute).

By contrast to systems provided in the art, the paper-in-resin electronics technology provides a device wherein each layer can present its circuitry and its electronics functions. In addition in the assembly of the invention, when electronics functions require barrier protection or thermal sinking, the impregnating resin brings this protection and performs the role of thermal vector.

## Claims

1. An electronic device comprising a plurality of sheets assembled in a direction perpendicular to the plane of the sheets, wherein at least one of said sheets is a sheet of paper comprising a printed trace, pattern, and/or layer of an electronic ink, wherein at least one sheet is appended with a plurality of not-printed electronic components chosen from a resistor, a capacitor, a diode, an inductor, a transistor, an electrode, an integrated circuit (IC), a switch, a piezoelectric device, an antenna, a battery, and, a transducer, a logic gate, a sensor or a wire and wherein the electronic components are connected together to create an electronic circuitry, **characterized in that**
the assembly of plurality of sheets is impregnated and encapsulated with a resin in a form of a flat or curved monolithic structure after appending the plurality of not-printed electronic components.

2. The electronic device according to claim 1, wherein at least two of the paper sheets comprise printed traces, patterns, and/or layers of a conductive ink.

3. The electronic device according to claim 1 or 2, wherein at least one paper sheet comprises:
a printed trace or layer of a semiconductive ink and/or,
a printed trace or layer of a dielectric ink.

4. The electronic device according to claim 3, wherein at least one paper sheet comprises one or more traces, patterns, and/or layers of a conductive ink, and/or one or more traces, patterns, and/or layers of a semiconductive ink, and/or one or more traces, patterns, and/or layers of a dielectric ink.

5. The electronic device according to any one of claims 1 to 4, wherein at least one paper sheet comprises one or more types of conductive inks, and/or one or more types of semiconductive inks, and/or one or more types of dielectric inks in particular wherein one or more traces, patterns, and/or layers of electronic ink, in particular of conductive inks, and/or semiconductive inks, and/or dielectric inks overlap in various arrangements and optionally wherein the device further comprises one or more discrete rigid electronic components.

6. The electronic device according to any one of claims 1 to 5, wherein each sheet in the plurality of sheets is a sheet of paper, in particular wherein at least one sheet of paper is a Kraft paper, a decor paper, a tracing paper or any combinations thereof.

7. The electronic device according to any one of claims 1 to 6, wherein the sheet on which the conductive ink, and/or semiconductive ink, and/or dielectric ink is printed is a coated paper and the coating comprises a binder and pigments.

8. The electronic device according to claim 7, wherein the coated paper has at least one of the following features:
a. It contains a coating composition comprising a binder with a glass transition temperature lower than 20°C, in particular wherein the coating comprises 5 to 50 parts by dry weight of such binder per 100 parts total dry matter of this coating composition, and/or the paper has an ISO brightness and/or D65 brightness in the range 70 to 90;
b. It comprises 0.05 to 15 parts dry weight of viscosifying agent, more preferably 0.05 to 5 parts dry weight, and still more preferably 0.05 to 4 parts dry weight of such an agent;
c. It has a Bekk smoothness equal to or higher than 900 s and/or a gloss at 75° equal to or higher than 70%.

9. The electronic device according to claim 8, wherein the coating comprises a binder chosen among acrylic polymer, polyurethane, polymethyl methacrylate, styrene butadiene, vinyl acetate, polyamide, nitrocellulose or any other cellulose, polyvinyl alcohol, starch or a mixture thereof.

10. The electronic device according to any one of claims 1 to 9, wherein:
a. the conductive ink comprises metallic microparticles or nanoparticles and/or conducting polymers, such as silver, carbon, silver chloride, and polylaniiline (PAni) and/or
b. the semiconductive ink comprises semiconducting microparticles or nanoparticles and/or semiconducting polymers, such as poly-3-alkylthiophene (P3AT) and/or
c. the dielectric ink comprises insulating polymers, such as polyhydroxystyrene (PHS).

11. The electronic device according to any of claims 1 to 10, wherein the resin comprises melamine formaldehyde (MF) resin, urea formaldehyde (UF) resin, urea-melamine formaldehyde (UMF) resin, acrylic resin, phenolic resin, polyester resin, epoxy resin, and mixtures thereof or is selected from melamine formaldehyde (MF) resin, urea formaldehyde (UF) resin, urea-melamine-formaldehyde (UMF) resin, acrylic resin, phenolic resin, polyester resin, epoxy resin, and mixtures thereof.

12. The electronic device according to any one of claims 1 to 11, which is a near field communication (NFC) device, a radio frequency identification (RFID) device, a Bluetooth device, a Wi-Fi device or other ultra-high frequency device, a photovoltaic cell, an emissive display, an energy harvesting device, a loudspeaker, selective electromagnetic shielding or a multi-layer printed circuit board (PBC) replacement.

13. An object which comprises the electronic device according to any one of claims 1 to 12, wherein the electronic device is integrated into the object, in particular a manufactured product which comprises at least one electronic device integrated into its structure.

14. A method for producing an electronic device according to any one of claims 1 to 12, comprising the steps of:
providing or producing a plurality of sheets, wherein at least one of said sheets is a paper comprising a printed trace, pattern, and/or layer of an electronic ink, and wherein at least one sheet is appended with a plurality of not-printed electronic components chosen from a resistor, a capacitor, a diode, an inductor, a transistor, an electrode, an integrated circuit (IC), a switch, a piezoelectric device, an antenna, a battery, and, a transducer, a logic gate, a sensor or a wire and wherein the electronic components are connected together to create an electronic circuitry, and optionally providing or producing at least one sheet with a deposited or appended non-printed, in particular rigid, electronic component ;
(i) optionally impregnating and encapsulating individually one or more sheets provided or produced in step (i) with a resin;
(ii) assembling said plurality of sheets in a direction perpendicular to the plane of the sheets;
(iii) when step (ii) was not carried out, impregnating and encapsulating the plurality of sheets with a resin;
(iv) optionally laminating the plurality of resin impregnated and encapsulated sheets and,
(v) recovering a flat or curved monolithic structure.

15. The method according to claims 14, wherein:
a. the step (i) comprises a step of printing at least one sheet with one or more traces, patterns, and/or layers of one or more conductive inks, and/or one or more traces, patterns, and/or layers of one or more semiconductive inks, and/or one or more traces, patterns, and/or layers of one or more dielectric inks by inkjet printing, offset printing, gravure printing, screen printing, flexography, and/or electrophotography and/or,
b. the step (i) comprises a step of curing or sintering the electronic ink, in particular the conductive and/or semiconductive and/or dielectric ink by thermal annealing, photonic curing, or ultraviolet (UV)-radiation annealing.

16. The method according to claim 14 or 15, wherein the resin comprises melamine formaldehyde (MF) resin, urea formaldehyde (UF) resin, urea-melamine-formaldehyde (UMF) resin, acrylic resin, phenolic resin, polyester resin, epoxy resin and mixtures thereof or is selected from these resins or mixtures thereof.

17. The method according to any one of claims 14 to 16, wherein step (v) is carried out under a pressure in the range of 20 to 100 bars and a temperature in the range of 120 to 200 °C for a duration of 15 seconds to 90 minutes, in particular for low pressure lamination process (LPL), a pressure in the range of 20 to 30 bars is applied at a temperature range in the range of 150 to 180 °C fora duration of 15 to 150 seconds or in particular, for high pressure lamination process (HPL), a pressure in the range of 40 to 100 bars is applied at a temperature in the range of 120 to 180 °C fora duration of 30 to 60 minutes.

18. The method according to any one of the claims 14 to 17, wherein the electronic device is defined in claims 1 to 13.

19. Use of the electronic device according to any one of the claims 1 to 13 for the manufacture of an object, wherein the electronic device is integrated into said object by lamination process.

## Patentansprüche

1. Eine elektronische Vorrichtung, die eine Vielzahl von Lagen umfasst, zusammenmontiert in einer Richtung senkrecht zu der Ebene der Lagen, wobei mindestens eine der Lagen eine Lage Papier ist, die eine gedruckte Leiterbahn, ein Muster und/oder eine Schicht einer elektronischen Tinte umfasst; wobei mindestens einer Lage eine Vielzahl nicht gedruckter elektronischer Komponenten hinzugefügt ist, gewählt aus einem Widerstand, einem Kondensator, einer Diode, einem Induktor, einem Transistor, einer Elektrode, einem integrierten Schaltkreis (integrated circuit, IC), einem Schalter, einer piezoelektrischen Vorrichtung, einer Antenne, einer Batterie und einem Wandler, einem Logikelement, einem Sensor oder einem Draht, und wobei die elektronischen Komponenten miteinander verbunden sind, um eine elektronische Schaltung zu erzeugen; **dadurch gekennzeichnet, dass** die Anordnung der Vielzahl von Lagen nach Hinzufügen der Vielzahl nicht gedruckter elektronischer Komponenten in Form einer flachen oder gekrümmten monolithischen Struktur mit einem Harz imprägniert und eingekapselt ist.

2. Die elektronische Vorrichtung gemäß Anspruch 1, wobei mindestens zwei der Papierlagen gedruckte Leiterbahnen, Muster und/oder Schichten einer leitenden Tinte umfassen.

3. Die elektronische Vorrichtung gemäß Anspruch 1 oder 2, wobei mindestens eine Papierlage Folgendes umfasst:
eine gedruckte Leiterbahn oder Schicht einer halbleitenden Tinte und/oder
eine gedruckte Leiterbahn oder Schicht einer dielektrischen Tinte.

4. Die elektronische Vorrichtung gemäß Anspruch 3, wobei mindestens eine Papierlage eine oder mehrere Leiterbahnen, Muster und/oder Schichten einer leitenden Tinte und/oder eine oder mehrere Leiterbahnen, Muster und/oder Schichten einer halbleitenden Tinte und/oder eine oder mehrere Leiterbahnen, Muster und/oder Schichten einer dielektrischen Tinte umfasst.

5. Die elektronische Vorrichtung gemäß einem beliebigen der Ansprüche 1 bis 4, wobei mindestens eine Papierlage eine oder mehrere Arten von leitenden Tinten und/oder eine oder mehrere Arten von halbleitenden Tinten und/oder eine oder mehrere Arten von dielektrischen Tinten umfasst, wobei sich im Speziellen eine oder mehrere Leiterbahnen, Muster und/oder Schichten elektronischer Tinte, insbesondere leitender Tinte und/oder halbleitender Tinte und/oder dielektrischer Tinte, in verschiedenen Anordnungen überlagern und wobei die Vorrichtung wahlweise weiter eine oder mehrere diskrete starre elektronische Komponenten umfasst.

6. Die elektronische Vorrichtung gemäß einem beliebigen der Ansprüche 1 bis 5, wobei jede Lage der Vielzahl von Lagen eine Lage Papier ist, wobei im Speziellen mindestens eine Lage Papier ein Kraftpapier, ein Dekorpapier, ein Pauspapier oder eine beliebige Kombination davon ist.

7. Die elektronische Vorrichtung gemäß einem beliebigen der Ansprüche 1 bis 6, wobei die Lage, auf welcher die leitende Tinte und/oder die halbleitende Tinte und/oder die dielektrische Tinte gedruckt wird, ein beschichtetes Papier ist und die Beschichtung ein Bindemittel und Pigmente umfasst.

8. Die elektronische Vorrichtung gemäß Anspruch 7, wobei das beschichtete Papier mindestens eines der folgenden Merkmale aufweist:
a. Es enthält eine Beschichtungszusammensetzung, die ein Bindemittel mit einer Glasübergangstemperatur unterhalb von 20°C umfasst, wobei die Beschichtung im Speziellen 5 bis 50 Teile Trockengewicht eines solchen Bindemittels je 100 Teile Gesamt-Trockenmasse dieser Beschichtungszusammensetzung umfasst und/oder das Papier eine ISO-Weiße und/oder D65-Weiße im Bereich von 70 bis 90 hat;
b. Es umfasst 0,05 bis 15 Teile Trockengewicht eines Verdickungsmittels, stärker bevorzugt 0,05 bis 5 Teile Trockengewicht und noch stärker bevorzugt 0,05 bis 4 Teile Trockengewicht eines solchen Mittels;
c. Es hat eine Glätte nach Bekk gleich oder höher als 900 s und/oder einen Glanz bei 75° gleich oder höher als 70%.

9. Die elektronische Vorrichtung gemäß Anspruch 8, wobei die Beschichtung ein Bindemittel umfasst, gewählt aus Acrylpolymer, Polyurethan, Polymethylmethacrylat, Styrolbutadien, Vinylacetat, Polyamid, Nitrocellulose oder eine beliebige andere Cellulose, Polyvinylalkohol, Stärke oder eine Mischung davon.

10. Die elektronische Vorrichtung gemäß einem beliebigen der Ansprüche 1 bis 9, wobei
a. die leitende Tinte metallische Mikropartikel oder Nanopartikel und/oder leitende Polymere umfasst, wie zum Beispiel Silber, Kohlenstoff, Silberchlorid und Polyanilin (PAni), und/oder
b. die halbleitende Tinte halbleitende Mikropartikel oder Nanopartikel und/oder halbleitende Polymere umfasst, wie zum Beispiel Poly-3-alkylthiophen (P3AT), und/oder
c. die dielektrische Tinte isolierende Polymere umfasst, wie zum Beispiel Polyhydroxystyrol (PHS).

11. Die elektronische Vorrichtung gemäß einem beliebigen der Ansprüche 1 bis 10, wobei das Harz Melaminformaldehyd-(MF-)Harz, Ureaformaldehyd-(UF-)Harz, Urea-Melaminformaldehyd-(UMF-)Harz, Acrylharz, Phenolharz, Polyesterharz, Epoxidharz und Mischungen davon umfasst oder gewählt ist aus Melaminformaldehyd-(MF-)Harz, Ureaformaldehyd-(UF-)Harz, Urea-Melaminformaldehyd-(UMF-)Harz, Acrylharz, Phenolharz, Polyesterharz, Epoxidharz und Mischungen davon.

12. Die elektronische Vorrichtung gemäß einem beliebige der Ansprüche 1 bis 11, die eine Nahbereichskommunikations-(near field communication, NFC)Vorrichtung, eine Hochfrequenzidentifikations-(radio frequency identification, RFID) Vorrichtung, eine Bluetooth-Vorrichtung, eine Wi-Fi-Vorrichtung oder andere Ultrahochfrequenz-Vorrichtung, eine photovoltaische Zelle, eine emissive Anzeige, eine Energy Harvesting-Vorrichtung, ein Lautsprecher, selektive elektromagnetische Abschirmung oder ein Ersatz für eine Mehrlagenleiterplatte (multi-layer printed circuit board, PBC) ist.

13. Ein Gegenstand, der die elektronische Vorrichtung gemäß einem beliebigen der Ansprüche 1 bis 12 umfasst, wobei die elektronische Vorrichtung in den Gegenstand, im Speziellen ein Erzeugnis, das mindestens eine in seine Struktur integrierte elektronische Vorrichtung umfasst, integriert ist.

14. Ein Verfahren zur Herstellung einer elektronischen Vorrichtung gemäß einem beliebigen der Ansprüche 1 bis 12, das folgende Schritte umfasst:
das Bereitstellen oder Herstellen einer Vielzahl von Lagen, wobei mindestens eine der Lagen ein Papier ist, das eine gedruckte Leiterbahn, ein Muster und/oder eine Schicht einer elektronischen Tinte umfasst; und wobei mindestens einer Lage eine Vielzahl nicht gedruckter elektronischer Komponenten hinzugefügt ist, gewählt aus einem Widerstand, einem Kondensator, einer Diode, einem Induktor, einem Transistor, einer Elektrode, einem integrierten Schaltkreis (integrated circuit, IC), einem Schalter, einer piezoelektrischen Vorrichtung, einer Antenne, einer Batterie und einem Wandler, einem Logikelement, einem Sensor oder einem Draht, und wobei die elektronischen Komponenten miteinander verbunden sind, um eine elektronische Schaltung zu erzeugen; und wahlweise das Bereitstellen oder Herstellen mindestens einer Lage mit einer aufgebrachten oder angehängten nicht gedruckten, im Speziellen starren, elektronischen Komponente;
(i) das optionale Imprägnieren und Einkapseln einer oder mehrerer Lagen, die in Schritt (i) bereitgestellt oder hergestellt wurden, einzeln mit einem Harz;
(ii) das Zusammenmontieren der Vielzahl von Lagen in einer Richtung senkrecht zu der Ebene der Lagen;
(iii) wenn Schritt (ii) nicht durchgeführt wurde, das Imprägnieren und Einkapseln der Vielzahl von Lagen mit einem Harz;
(iv) wahlweise das Laminieren der Vielzahl mit Harz imprägnierter und eingekapselter Lagen und
(v) das Rückgewinnen einer flachen oder gekrümmten monolithischen Struktur.

15. Das Verfahren gemäß Anspruch 14, worin
a. der Schritt (i) einen Schritt des Bedruckens mindestens einer Lage mit einer oder mehreren Leiterbahnen, Mustern und/oder Schichten einer oder mehrerer leitender Tinten und/oder einer oder mehreren Leiterbahnen, Mustern und/oder Schichten einer oder mehrerer halbleitender Tinten und/oder einer oder mehreren Leiterbahnen, Mustern und/oder Schichten einer oder mehrerer dielektrischer Tinten durch Tintenstrahldrucken, Offset-Drucken, Tiefdruck, Siebdruck, Flexodruck und/oder Elektrophotographie umfasst und/oder
b. der Schritt (i) einen Schritt des Härtens oder Sinterns der elektronischen Tinten, im Speziellen der leitenden und/oder halbleitenden und/oder dielektrischen Tinte, durch thermische Behandlung, photonische Härtung oder Tempern durch ultraviolette (UV-)Strahlung umfasst.

16. Das Verfahren gemäß Anspruch 14 oder 15, wobei das Harz Melaminformaldehyd-(MF-)Harz, Ureaformaldehyd-(UF-)Harz, Urea-Melaminformaldehyd-(UMF-)Harz, Acrylharz, Phenolharz, Polyesterharz, Epoxidharz und Mischungen davon umfasst oder aus diesen Harzen oder Mischungen davon gewählt ist.

17. Das Verfahren gemäß einem beliebigen der Ansprüche 14 bis 16, worin Schritt (v) bei einem Druck im Bereich von 20 bis 100 bar und einer Temperatur im Bereich von 120 bis 200°C über eine Dauer von 15 Sekunden bis 90 Minuten durchgeführt wird; im Speziellen wird, in einem Niederdruckbeschichtungsverfahren (low pressure lamination process, LPL), ein Druck im Bereich von 20 bis 30 bar in einem Temperaturbereich von 150 bis 180°C über eine Dauer von 15 bis 150 Sekunden ausgeübt; oder im Speziellen wird, in einem Hochdruckbeschichtungsverfahren (high pressure lamination process, HPL), ein Druck im Bereich von 40 bis 100 bar bei einer Temperatur im Bereich von 120 bis 180°C über eine Dauer von 30 bis 60 Minuten ausgeübt.

18. Das Verfahren gemäß einem beliebigen der Ansprüche 14 bis 17, worin die elektronische Vorrichtung in den Ansprüchen 1 bis 13 definiert ist.

19. Verwendung der elektronischen Vorrichtung gemäß einem beliebigen der Ansprüche 1 bis 13 zur Herstellung eines Gegenstands, wobei die elektronische Vorrichtung in den Gegenstand durch ein Laminierverfahren integriert wird.

## Revendications

1. Un dispositif électronique comprenant une pluralité de feuilles assemblées dans une direction perpendiculaire au plan des feuilles, dans lequel au moins une desdites feuilles est une feuille de papier comprenant une trace imprimée, un motif et/ou une couche d'encre électronique, dans lequel au moins une feuille est pourvue d'une pluralité de composants électroniques non imprimés choisis parmi une résistance, un condensateur, une diode, une inductance, un transistor, une électrode, un circuit intégré (CI), un commutateur, un dispositif piézoélectrique, une antenne, une batterie et un transducteur, une porte logique, un capteur ou un fil, et dans lequel les composants électroniques sont connectés entre eux pour créer un circuit électronique, **caractérisé en ce que** l'assemblage de la pluralité de feuilles est imprégné et encapsulé avec une résine sous la forme d'une structure monolithique plate ou courbée après l'ajout de la pluralité de composants électroniques non imprimés.

2. Le dispositif électronique selon la revendication 1, dans lequel au moins deux des feuilles de papier comprennent des traces, des motifs et/ou des couches imprimés d'une encre conductrice.

3. Le dispositif électronique selon la revendication 1 ou 2, dans lequel au moins une feuille de papier comprend :
une trace ou une couche imprimée d'une encre semi-conductrice et/ou,
une trace ou une couche imprimée d'une encre diélectrique.

4. Le dispositif électronique selon la revendication 3, dans lequel au moins une feuille de papier comprend une ou plusieurs traces, motifs et/ou couches d'une encre conductrice, et/ou une ou plusieurs traces, motifs et/ou couches d'une encre semi-conductrice, et/ou une ou plusieurs traces, motifs et/ou couches d'une encre diélectrique.

5. Le dispositif électronique selon l'une quelconque des revendications 1 à 4, dans lequel au moins une feuille de papier comprend un ou plusieurs types d'encres conductrices, et/ou un ou plusieurs types d'encres semi-conductrices, et/ou un ou plusieurs types d'encres diélectriques, en particulier dans lequel une ou plusieurs traces, motifs et/ou couches d'encre électronique, en particulier d'encres conductrices, et/ou d'encres semi-conductrices, et/ou d'encres diélectriques se chevauchent selon diverses dispositions et, en option, dans lequel le dispositif comprend en outre un ou plusieurs composants électroniques rigides discrets.

6. Le dispositif électronique selon l'une quelconque des revendications 1 à 5, dans lequel chaque feuille de la pluralité de feuilles est une feuille de papier, en particulier dans lequel au moins une feuille de papier est un papier kraft, un papier décoratif, un papier calque ou toute combinaison de ceux-ci.

7. Le dispositif électronique selon l'une quelconque des revendications 1 à 6, dans lequel la feuille sur laquelle l'encre conductrice et/ou l'encre semi-conductrice et/ou l'encre diélectrique est imprimée est un papier couché et le revêtement comprend un liant et des pigments.

8. Le dispositif électronique selon la revendication 7, dans lequel le papier couché présente au moins l'une des caractéristiques suivantes :
a. Il contient une composition de revêtement comprenant un liant ayant une température de transition vitreuse inférieure à 20 °C, en particulier dans lequel le revêtement comprend 5 à 50 parties en poids sec dudit liant pour 100 parties de matière sèche totale de cette composition de revêtement, et/ou le papier a une luminosité ISO et/ou une luminosité D65 comprise entre 70 et 90 ;
b. Il comprend 0,05 à 15 parties en poids sec d'agent viscosifiant, de préférence 0,05 à 5 parties en poids sec, et plus préférablement encore 0,05 à 4 parties en poids sec d'un tel agent ;
c. II présente une douceur Bekk égale ou supérieure à 900 s et/ou une brillance à 75° égale ou supérieure à 70 %.

9. Le dispositif électronique selon la revendication 8, dans lequel le revêtement comprend un liant choisi parmi un polymère acrylique, un polyuréthane, un polyméthacrylate de méthyle, un styrène-butadiène, un acétate de vinyle, un polyamide, une nitrocellulose ou toute autre cellulose, un alcool polyvinylique, un amidon ou un mélange de ceux-ci.

10. Le dispositif électronique selon l'une quelconque des revendications 1 à 9, dans lequel :
a. l'encre conductrice comprend des microparticules ou des nanoparticules métalliques et/ou des polymères conducteurs, tels que l'argent, le carbone, le chlorure d'argent et la polylaniiline (PAni) et/ou
b. l'encre semi-conductrice comprend des microparticules ou des nanoparticules semi-conductrices et/ou des polymères semi-conducteurs, tels que le poly-3-alkylthiophène (P3AT) et/ou
c. l'encre diélectrique comprend des polymères isolants, tels que le polyhydroxystyrène (PHS).

11. Le dispositif électronique selon l'une quelconque des revendications 1 à 10, dans lequel la résine comprend une résine mélamine-formaldéhyde (MF), une résine urée-formaldéhyde (UF), une résine urée-mélamine-formaldéhyde (UMF), une résine acrylique, une résine phénolique, une résine polyester, une résine époxy, et des mélanges de celles-ci, ou est choisie parmi la résine mélamine-formaldéhyde (MF), la résine urée-formaldéhyde (UF), la résine urée-mélamine-formaldéhyde (UMF), la résine acrylique, la résine phénolique, la résine polyester, la résine époxy et des mélanges de celles-ci.

12. Le dispositif électronique selon l'une quelconque des revendications 1 à 11, qui est un dispositif de communication en champ proche (NFC), un dispositif d'identification par radiofréquence (RFID), un dispositif Bluetooth, un dispositif Wi-Fi ou un autre dispositif à ultra-haute fréquence, une cellule photovoltaïque, un écran émetteur, un dispositif de récupération d'énergie, un haut-parleur, un blindage électromagnétique sélectif ou un remplacement de carte de circuit imprimé multicouche (PBC).

13. Un objet qui comprend le dispositif électronique selon l'une quelconque des revendications 1 à 12, où le dispositif électronique est intégré dans l'objet, en particulier un produit manufacturé qui comprend au moins un dispositif électronique intégré dans sa structure.

14. Un procédé de fabrication d'un dispositif électronique selon l'une quelconque des revendications 1 à 12,
comprenant les étapes consistant à :
fournir ou produire une pluralité de feuilles, où au moins une desdites feuilles est un papier comprenant une trace imprimée, un motif et/ou une couche d'encre électronique, et où au moins une feuille est munie d'une pluralité de composants électroniques non imprimés choisis parmi une résistance, un condensateur, une diode, une inductance, un transistor, une électrode, un circuit intégré (CI), un commutateur, un dispositif piézoélectrique, une antenne, une batterie et un transducteur, une porte logique, un capteur ou un fil, et où les composants électroniques sont connectés entre eux pour créer un circuit électronique, et éventuellement fournir ou produire au moins une feuille avec un composant électronique non imprimé, en particulier rigide, déposé ou ajouté ;
(i) imprégner et encapsuler individuellement, de manière facultative, une ou plusieurs feuilles fournies ou produites à l'étape (i) avec une résine ;
(ii) assembler ladite pluralité de feuilles dans une direction perpendiculaire au plan des feuilles ;
(iii) lorsque l'étape (ii) n'a pas été effectuée, imprégner et encapsuler la pluralité de feuilles avec une résine ;
(iv) éventuellement, laminer la pluralité de feuilles imprégnées et encapsulées de résine, et
(v) récupérer une structure monolithique plate ou courbée.

15. Le procédé selon la revendication 14, dans lequel :
a. l'étape (i) comprend une étape d'impression d'au moins une feuille avec une ou plusieurs traces, motifs et/ou couches d'une ou plusieurs encres conductrices, et/ou une ou plusieurs traces, motifs et/ou couches d'une ou plusieurs encres semi-conductrices, et/ou une ou plusieurs traces, motifs et/ou couches d'une ou plusieurs encres diélectriques par impression à jet d'encre, impression offset, impression héliographique, sérigraphie, flexographie et/ou électrophotographie et/ou,
b. l'étape (i) comprend une étape de durcissement ou de frittage de l'encre électronique, en particulier de l'encre conductrice et/ou semi-conductrice et/ou diélectrique, par recuit thermique, durcissement photonique ou recuit par rayonnement ultraviolet (UV).

16. Le procédé selon la revendication 14 ou 15, dans lequel la résine comprend une résine de mélamine formaldéhyde (MF), de résine urée-formaldéhyde (UF), de résine urée-mélamine-formaldéhyde (UMF), de résine acrylique, de résine phénolique, de résine polyester, de résine époxy et de mélanges de celles-ci, ou est choisie parmi ces résines ou mélanges de celles-ci.

17. Le procédé selon l'une quelconque des revendications 14 à 16, dans lequel l'étape (v) est réalisée sous une pression comprise entre 20 et 100 bars et à une température comprise entre 120 et 200 °C pendant une durée de 15 secondes à 90 minutes, en particulier pour un procédé de stratification à basse pression (LPL), une pression comprise entre 20 et 30 bars est appliquée à une température comprise entre 150 et 180 °C pendant une durée de 15 à 150 secondes ou, en particulier, pour un procédé de stratification à haute pression (HPL), une pression comprise entre 40 et 100 bars est appliquée à une température comprise entre 120 et 180 °C pendant une durée de 30 à 60 minutes.

18. Le procédé selon l'une quelconque des revendications 14 à 17, dans lequel le dispositif électronique est défini dans les revendications 1 à 13.

19. Utilisation du dispositif électronique selon l'une quelconque des revendications 1 à 13 pour la fabrication d'un objet, dans laquelle le dispositif électronique est intégré dans ledit objet par un procédé de stratification.
